Europäisches Patentamt

European Patent Office

Office européen des brevets

(19)

(11) **EP 0 709 690 B1**

(12) **EUROPÄISCHE PATENTSCHRIFT**

(45) Veröffentlichungstag und Bekanntmachung des Hinweises auf die Patenterteilung:
**31.07.2002 Patentblatt 2002/31**

(51) Int Cl.⁷: **G01R 33/561**

(21) Anmeldenummer: **95202829.8**

(22) Anmeldetag: **19.10.1995**

(54) **MR-Verfahren und Anordnung zur Durchführung desselben**

MR method and apparatus for carrying out the method

Procédé RM et dispositif pour sa mise en oeuvre

(84) Benannte Vertragsstaaten:
**DE FR GB NL**

(30) Priorität: **28.10.1994 DE 4438488**

(43) Veröffentlichungstag der Anmeldung:
**01.05.1996 Patentblatt 1996/18**

(73) Patentinhaber:
• **Philips Corporate Intellectual Property GmbH 52064 Aachen (DE)**
Benannte Vertragsstaaten:
**DE**
• **Koninklijke Philips Electronics N.V. 5621 BA Eindhoven (NL)**
Benannte Vertragsstaaten:
**FR GB NL**

(72) Erfinder: **Bömert, Peter, Dr., c/o Philips D-22335 Hamburg (DE)**

(74) Vertreter: **Hartmann, Heinrich, Dipl.-Ing. Philips Corporate Intellectual Property GmbH, Habsburgerallee 11 52064 Aachen (DE)**

(56) Entgegenhaltungen:
**EP-A- 0 644 437          WO-A-93/01509 DE-A- 4 005 675**

• **PROC. SOC. MAGN. RES. MED., Bd. 3, August 1993 NEW YORK, Seite 1239 A. JESMANOWICZ: 'Phase Correction for EPI Using Internal Reference Lines'**

EP 0 709 690 B1

**Beschreibung**

Die Erfindung betrifft ein MR-Verfahren mit folgenden Schritten:

a) Anregen der Kernmagnetisierung in einem Untersuchungsbereich, der einem homogenen stationären Magnetfeld ausgesetzt ist, durch eine Sequenz mit wenigstens einem Hochfrequenzimpuls
b) Danach Erzeugen eines Lesegradienten mit alternierender Polarität und gleichzeitige Erzeugung eines Phasenkodiergradienten
c) Erfassen der nach den Polaritätswechseln des Lesegradienten auftretenden MR-Signale zur Gewinnungvon MR-Rohdaten
d) Korrektur der MR-Rohdaten durch MR-Korrekturdaten, die aus MR-Signalen abgeleitet werden, die in derselben Sequenz und bei dem gleichen zeitlichen Verlauf des Lesegradienten - aber ohne Phasenkodierung - erfaßt werden
e) Rekonstruktion der Kernmagnetisierungsverteilung aus den korrigierten MR-Rohdaten.

Es ist bekannt, daß bei einem MR-Verfahren, bei dem mehrere MR-Signale nacheinander bei jeweils alternierender Polarität des Lesegradienten erfaßt werden, Unvollkommenheiten des MR-Systems zu Phasenfehlern führen, die ihrerseits sogenannte N/2 Geisterbilder zur Folge haben.

Um diese zu vermeiden, wird bei einem aus der EP-OS 490 528 bekannten MR-Verfahren neben einer ersten Sequenz, in der die MR-Rohdaten erfaßt werden, eine zweite Sequenz durchgeführt, in der - ohne einen Phasenkodiergradienten - genauso viele MR-Signale erfaßt werden wie in der ersten Sequenz, woraus MR-Korrekturdaten abgeleitet werden. Dadurch wird die Meßzeit verdoppelt. Außerdem müssen die beiden Sequenzen einen zeitlichen Abstand voneinander haben, der ausreicht, um die durch die erste Sequenz angeregte Kernmagnetisierung abklingen zu lassen, bevor die zweite Sequenz beginnt. Dieser Zeitraum liegt in der Größenordnung von einer Sekunde. Eine evtl. notwendige Wartezeit und die vergrößerte Meßzeit sind insbesondere dann von Nachteil, wenn es um die Echtzeitanwendungen geht, beispielsweise dann, wenn fortlaufend die Kernmagnetisierungsverteilung in verschiedenen, ständig in ihrer Orientierung wechselnden und zueinander nicht parallelen Schichten ermittelt wird.

Diesen Nachteil vermeidet das Verfahren, das aus einem Aufsatz von Jesmanowicz et al in "SMRM Book of Abstracts", Aug. 1993, Seite 1239 bekannt ist. Hierbei werden die Korrekturdaten aus zwei MR-Signalen abgeleitet, die im Zuge einer EPI-Sequenz nacheinander bei positiver und negativer Polarität auftreten, wenn das zeitliche Integral über den Phasenkodiergradienten den Wert Null erreicht hat. Aus diesen beiden MR-Signalen lassen sich Korrekturdaten für die bei positiver Polarität des Lesegradienten einerseits und für die bei negativer Polarität des Lesegradienten andererseits gewonnenen MR-Rohdaten ableiten. Allerdings arbeitet dieses Verfahren nur dann zufriedenstellend, wenn die Phasenfehler sich zeitlich nicht verändern. Bei örtlich inhomogenem stationären Magnetfeld ergeben sich jedoch zeitlich veränderliche Phasenfehler, die mit dem bekannten MR-Verfahren nicht eliminiert werden können, so daß die N/2 Geisterbilder nach wie vor auftreten. Außerdem können wirbelstrombedingte Phasenfehler ebenfalls nicht erfaßt werden.

Aufgabe der vorliegenden Erfindung ist es, ein Verfahren der eingangs genannten Art so auszugestalten, daß einerseits die erforderlichen MR-Signale genügend schnell akquiriert werden können und daß andererseits die Phasenfehler bzw. die daraus resultierenden Bildfehler weitestgehend unterdrückt werden können.

Diese Aufgabe wird erfindungsgemäß dadurch gelöst, daß bei positiver Polarität und bei negativer Polarität des Lesegradienten $(G_x)$ insgesamt mindestens drei von dem Phasenkodiergradienten $(G_y)$ unbeeinflußte MR-Signale erfaßt werden und daß aus diesen MR-Signalen bzw. den daraus durch eine Fouriertransformation erhaltenen MR-Daten die MR-Korrekturdaten abgeleitet werden.

Bei der Erfindung werden die MR-Signale, aus denen die MR-Korrekturdaten abgeleitet werden, in der gleichen Sequenz akquiriert, in der die phasenkodierten MR-Signale erfaßt werden, aus denen das Bild der Kernmagnetisierungsverteilung nach der Korrektur rekonstruiert wird. Es werden bei positiver und bei negativer Polarität des Lesegradienten insgesamt mindestens drei MR-Signale ohne Phasenkodierung erfaßt. Damit ist es beispielsweise möglich, Phasenfehler zu eliminieren, die durch Wirbelstromeffekte bedingt sind.

Es sei an dieser Stelle erwähnt, daß in der nicht vorveröffentlichten, aber älteren Anmeldung EP-A- 0 644 437 ein Verfahren der eingangs genannten Art beschrieben ist, bei dem zwei mit der gleichen Phasenkodierung akquirierte MR-Signale zur Korrektur der MR-Signale herangezogen werden, die nach dem gleichen Hochfrequenzimpuls akquiriert wurden.

Bei zeitlich veränderlichen Phasenfehlern ist eine Korrektur dadurch möglich,

-    daß der Phasenfehlerverlauf (z. B. $\alpha(t_1,x),\alpha(t_3,x)$) dieser MR-Signale bzw der daraus durch eine Fouriertransformation abgeleiteten MR-Daten $(S(t_1,x),S(t_3,x))$ bestimmt wird und
-    daß aus der zeitlichen Änderung $(da_0,da_1; db_0,db_1)$ von der gleichen Polarität des Lesegradienten zugeordneten Phasenfehlerverläufen $(\alpha(t_1,x),\alpha(t_3,x))$ der Phasenfehlerverlauf $(\alpha(t,x))$ von bei dieser Polarität des Lesegradienten in einem anderen Zeitpunkt (t) erfaßten MR-Signalen bzw daraus abgeleiteten MR-Rohdaten (S(t,x)) geschätzt wird und die MR-Rohdaten entsprechend korrigiert werden.

Es hat sich nämlich gezeigt, daß in der Regel auch die Phasenfehlerverläufe voneineinander abweichen, die bei der gleichen Polarität des Lesegradienten - aber zu einem unterschiedlichen Zeitpunkt - erfaßt wurden. Aus diesen zeitlichen Änderungen läßt sich der Phasenfehlerverlauf - z.B. durch lineare oder quadratische Interpolation bzw. Extrapolation - abschätzen, der sich für ein zu einem anderen Zeitpunkt innerhalb der Sequenz mit Phasenkodierung erfaßtes MR-Signal ergibt, und die MR-Rohdaten können entsprechend korrigiert werden. Wenn man von einer zeitlich linearen Änderung des Phasenverlaufs ausgeht - was meistens ausreicht - muß man bei posistiver wie bei negativer Polarität des Lesegradienten (mindestens) je zwei MR-Signale ohne Phasenkodierung heranziehen und bei einer zeitlich quadratischen Änderung (mindestens) je drei MR-Signale.

Auch wenn die Phasenfehler der MR-Rohdaten vollständig beseitigt würden, könnten immer noch Geisterbilder auftreten, und zwar dann, wenn der Frequenzgang des MR-Systems, mit dem das erfindungsgemäße Verfahren durchgeführt wird, unsymmetrisch ist bezüglich der Mittenfrequenz der MR-Signale. Diese Bildartefakte lassen sich nach einer bevorzugten Weiterbildung der Erfindung dadurch beseitigen, daß aus den MR-Daten Korrekturfaktoren abgeleitet werden, und daß die bei der gleichen Polarität des Lesegradienten gewonnenen MR-Rohdaten mit diesen Korrekturfaktoren multipliziert werden. Vorzugsweise sind diese Korrekturfaktoren umso größer, je kleiner die MR-Rohdaten sind. Es sei bemerkt, daß aus der DE-OS 4 005 675 der Einfluß der Frequenzabhängigkeit des MR-Systems, dessen Auswirkungen auf die MR-Bilder sowie die Beseitigung dieser Auswirkungen bekannt sind. Allerdings müssen dabei immer zwei Sequenzen durchgeführt werden - eine mit und eine ohne Phasenkodiergradienten.

Eine Weiterbildung der Erfindung sieht vor, daß die Sequenz einen Korrektur-Zeitabschnitt, in dem die zur Bildung der MR-Korrekturdaten herangezogenen MR-Signale während eines Lesegradienten mit alternierender Polarität ohne Phasenkodierung erfaßt werden, und danach wenigstens einen Meß-Zeitabschnitt aufweist, in dem die zur Bildung der Meßdaten herangezogenen MR-Signale während eines Lesegradienten mit alternierender Polarität bei gleichzeitiger Einwirkung eines Phasenkodierungsgradienten erfaßt werden. Dabei weisen die MR-Signale, aus denen die MR-Korrekturdaten abgeleitet werden, das beste Signal-Rausch-Verhältnisse aller MR-Signale innerhalb der Sequenz auf, weil sie den kürzesten Abstand von dem Hochfrequenzimpuls haben.

In weiterer Ausgestaltung der Erfindung ist vorgesehen, daß die Sequenz einen die Kernmagnetisierung anregenden Hochfrequenzimpuls und danach einen die Kernmagnetisierung invertierenden Hochfrequenzimpuls umfaßt, und daß der Korrektur-Zeitabschnitt zwischen den beiden Hochfrequenzimpulsen liegt und der Meß-Zeitabschnitt nach dem invertierenden Hochfrequenzimpuls. Grundsätzlich könnte der Korrekturzeitabschnitt auch zwischen dem invertierenden Hochfrequenz- und dem Meßzeitabschnitt liegen, doch ist es vorteilhafter, wenn der Korrekturzeitabschnitt zwischen den beiden Hochfrequenzimpulsen liegt.

Ein MR-Gerät zur Durchführung des Verfahrens nach der Erfindung, das ausgeht von

a) einem Hauptfeldmagneten zur Erzeugung eines homogenen stationären Magnetfeldes,
b) einer Gradienten-Spulenanordnung zur Erzeugung eines Lesegradienten mit alternierender Polarität und zur Erzeugung eines Phasenkodiergradienten,
c) einer Hochfrequenzspulenanordnung zum Anregen der Kernmagnetisierung in dem Untersuchungsbereich durch eine Sequenz mit wenigstens einen Hochfrequenzimpuls,
d) einem Empfänger zum Erfassen der während des Lesegradienten erzeugten MR-Signale,
e) Mitteln zur Korrektur der aus den MR-Signalen erzeugten MR-Rohdaten durch MR-Korrekturdaten, die aus MR-Daten ohne Phasenkodierung abgeleitet sind,
f) einer Rekonstruktionseinheit zur Rekonstruktion der Kernmagnetisierungsverteilung im Untersuchungsbereich aus den korrigierten MR-Meßdaten
g) einer Steuereinheit zur Steuerung der Gradientenspulenanordnung, der Hochfrequenzspulenanordnung und des Empfängers

ist dadurch gekennzeichnet, daß
die Steuereinheit die Gradientenspulenanordnung und den Empfänger so steuert, daß der Lesegradient und der Phasenkodiergradient während der Sequenz einen solchen zeitlichen Verlauf haben, daß während jeweils zwei oder jeweils drei Zeitabschnitten mit sowohl positiver als auch negativer Polarität des Lesegradienten je ein von dem Phasenkodiergradienten unbeeinflußtes MR-Signal erfaßt wird, das zur Ableitung der MR-Korrekturdaten herangezogen wird.

Die Erfindung wird nachstehend anhand der Zeichnungen näher erläutert. Es zeigt

Fig. 1    einen MR-Tomographen, mit dem die Erfindung ausführbar ist,
Fig. 2    das Blockschaltbild eines derartigen MR-Tomographen,
Fig. 3    den zeitlichen Verlauf verschiedener Signale bei der Erfassung der MR-Signale bei einer ersten Sequenz,

Fig. 4    ein Diagramm zur Erläuterung des Korrekturverfahrens,

Fig. 5    eine zweite Ausführungsform einer erfindungsgemäßen Sequenz und

Fig. 6    eine dritte Ausführungsform.

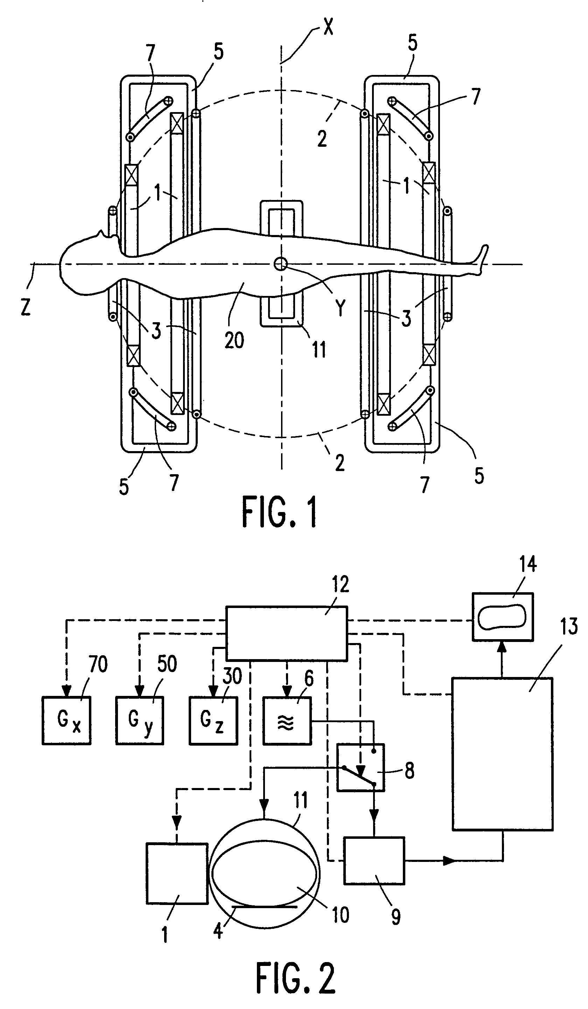

Das in Fig. 1 schematisch dargestellte MR-Gerät besitzt einen aus vier Spulen 1 bestehenden Hauptfeldmagneten, der ein homogenes stationäres Magnetfeld erzeugt, dessen magnetische Induktion in der Größenordnung von einigen zehntel Tesla bis einigen Tesla liegen kann. Im Innern des Hauptfeldmagneten befindet sich der zu untersuchende Patient 20 auf einer Tischplatte 4.

Zur Erzeugung eines in z-Richtung verlaufenden und sich in dieser Richtung linear ändernden Magnetfeldes $G_z$ sind vier Spulen 3 auf der Oberfläche 2 einer Kugel angeordnet. Weiterhin sind vier Spulen 7 vorgesehen, die ein ebenfalls in z-Richtung verlaufendes Magnetfeld $G_x$ erzeugen, das sich linear in x-Richtung (vertikal) ändert. Ein in z-Richtung verlaufendes Magnetfeld $G_y$, das sich linear in y-Richtung (senkrecht zur Zeichenebene der Fig. 1) ändert, wird von den vier Spulen 5 erzeugt, die mit den Spulen 7 identisch sein können, jedoch diesen gegenüber um 90° versetzt angeordnet sind und von denen nur zwei dargestellt sind. Die von den Gradientenspulen erzeugten Magnetfelder werden im folgenden vereinfacht als "Gradient" oder entsprechend ihrer Funktion als Lesegradient, Phasenkodiergradient oder Schichtselektionsgradient bezeichnet. Da jede der drei Spulenanordnungen 3, 5 und 7 symmetrisch zur Kugeloberfläche 2 angeordnet ist, ist die magnetische Induktion im Kugelzentrum nur durch das stationäre homogene Magnetfeld des Hauptfeldmagneten 1 bestimmt.

Weiterhin ist eine Hochfrequenzspule 11 vorgesehen, die ein im wesentlichen homogenes und senkrecht zur Richtung des stationären homogenen Magnetfeldes (d.h. senkrecht zur z-Richtung) verlaufendes hochfrequentes Magnetfeld erzeugt. Wie in Fig. 2 dargestellt, ist die Hochfrequenzspule 11 über einen Umschalter 8 wahlweise mit einem Oszillator 6 oder mit einem Empfänger 9 verbunden. Die Hochfrequenzspule kann in der dargestellten Stellung des Umschalters zum Empfangen der im Untersuchungsbereich erzeugten MR-Signale eingesetzt werden. Es ist jedoch auch möglich, zum Empfang der MR-Signale eine (oder mehrere) gesonderte, in Fig. 1 nicht näher dargestellte Hochfrequenzempfangsspule(n) zu verwenden. Im Empfänger 9 werden die MR-Signale phasenempfindlich detektiert und digitalisiert, so daß die vom Empfänger gelieferten MR-Daten als komplexe Zahlen (mit Betrag und Phase) aufgefaßt werden können.

Die zeitliche Lage der Hochfrequenzimpulse, ihre Bandbreite und ihre Mittenfrequenz sind von einer Steuereinheit 12 steuerbar, die auf den Oszillator 6 einwirkt. Die Ströme für die Gradientenspulenanordnungen 3, 5 und 7 werden von den Einheiten 30, 50 und 70 geliefert, die ihrerseits durch die Steuereinheit 12 gesteuert werden, so daß auch der zeitliche Verlauf der Gradienten durch die Steuereinheit 12 bestimmt wird. Außerdem ist eine Rekonstruktionseinheit 13 vorgesehen, die die in den Niederfrequenzbereich umgesetzten digitalisierten MR-Signale verarbeitet und daraus die Kernmagnetisierungsverteilung im Untersuchungsbereich rekonstruieren und auf einer Ausgabeeinheit 14 darstellen kann.

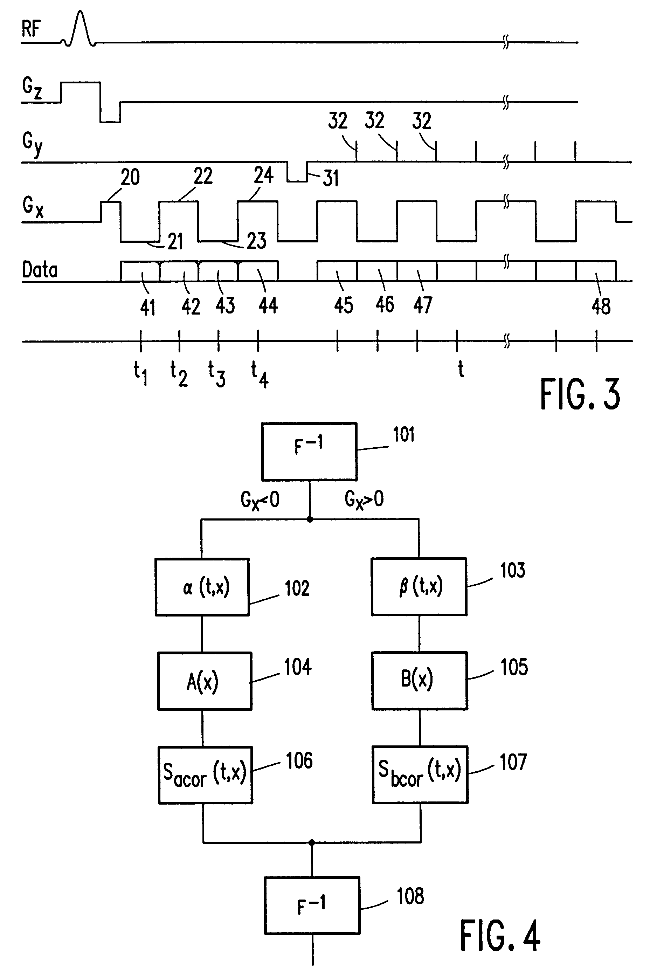

Fig. 3 zeigt die zeitliche Lage verschiedener Signale bei einer erfindungsgemäß modifizierten Sequenz vom EPI-Typ. Die erste Zeile zeigt die zeitliche Lage des Hochfrequenzimpulses RF. In der zweiten bis vierten Zeile ist der zeitliche Verlauf des Schichtselektionsgradienten $G_z$, des Phasenkodiergradienten $G_y$ und des Lesegradienten $G_x$ dargestellt. Dabei wurde angenommen, daß diese Gradienten in z-, y-, x-Richtung verlaufen, was jedoch nicht erforderlich ist; die Gradienten können in einer beliebigen Richtung im Raum verlaufen, vorzugsweise aber senkrecht zueinander. Die Erzeugung eines Gradienten mit beliebiger Richtung im Raum setzt allerdings voraus, daß die Einheiten 30, 50 und 70 gleichzeitig aktiviert sind, so daß sich die Gradienten der Spulen 3, 5 und 7 überlagern. Aus der fünften Zeile ergibt sich, wann die MR-Signale aufgenommen bzw. digitalisiert werden, und in der sechsten Zeile sind auf einer Zeitachse einige besondere Zeitpunkte eingetragen.

Die Sequenz beginnt mit einem schichtselektiven 90°-Hochfrequenzimpuls, d.h. der Hochfrequenzimpuls (1. Zeile) ist von einem Schichtselektionsgradienten $G_z$ (2. Zeile) begleitet, so daß im Untersuchungsbereich die Kernmagnetisierung nur in einer zur z-Achse senkrechten Schicht angeregt wird.

Nach dem Hochfrequenzimpuls wird der Lesegradient $G_x$ eingeschaltet, wobei er zunächst eine positive Polarität haben kann (20), dann eine negative (21), dann wieder eine positive (22) usw. Dabei ist der zeitliche Verlauf so gewählt, daß der Betrag des zeitlichen Integrals zwischen den Nulldurchgängen des Lesegradienten für den Gradientenimpuls 20 genau halb so groß ist wie die für alle nachfolgenden Gradientenimpulse 21, 22, 24. Das bedeutet, daß beim Empfang eines MR-Signales während eines der nachfolgenden positiven oder negativen Gradientenpulse der den Ortsfrequenzbereich beschreibende k-Raum längs einer geraden Linie abgetastet wird, deren Endpunkte vom Nullpunkt des k-Raums den gleichen Abstand haben.

Nachdem auf diese Weise bis zum Gradientenimpuls 24 der Gradient seine Polarität viermal umgekehrt hat, wird während des folgenden Impulses des Lesegradienten $G_x$ der Phasenkodiergradient $G_y$ ein- und ausgeschaltet (Impuls 31), wodurch die Phase des während des nächsten Lesegradienten erzeugten MR-Signals kodiert wird. Beim Nulldurchgang des Lesegradienten wird ein kurzer Gradientenimpuls (ein sogenannter "blip") 32 erzeugt, wodurch sich die Phasenkodierung des danach erzeugten MR-Signals ändert. Bei jedem weiteren Nulldurchgang des Lesegradienten werden weitere blips 32 erzeugt. Die blips 32 haben die entgegengesetzte Polarität wie der Impuls 31 des Phasenkodiergradienten, und das zeitliche Integral über den Impuls 31 beträgt ein Vielfaches des zeitlichen Integrals über einen blip 32, jedoch ist es kleiner als die Summe der zeitlichen Integrale über alle blips 32.

In den in Fig. 3 durch 41, 42, 43 und 44 angedeuteten Zeitintervallen, in denen Lesegradient seine Polarität nicht ändert und deren Mitten gemäß Zeile 6 von Fig. 3 mit $t_1, t_2, t_3$ und $t_4$ bezeichnet sind, wird jeweils ein vollständiges MR-Signal (bzw. ein sogenanntes "Gradienten-Echo") erfaßt. In den Zeitintervallen 41 und 43 hat derGradientenimpuls 21, 23 jeweils eine negative Polarität, und in den Zeitintervallen 42, 44 hat er (22, 24) eine positive Polarität . Nach dem Impuls 31 des Phasenkodiergradienten $G_y$ werden N MR-Signale während der Zeitintervalle 45, 46, 47 ... 48 erfaßt, wobei N wesentlich größer ist als 4 und z.B. 128 beträgt.

Die während der Zeitintervalle 41 ... 44 erfaßten MR-Signale sind frei von jeglicher Phasenkodierung. Im Idealfall - d.h. wenn das Hauptmagnetfeld völlig homogen wäre, wenn keine Relaxationsphänomene auftreten würden, und wenn das MR-System eine frequenzunabhängige Übertragungscharakteristik hätte - müßten diese MR-Signale bzw. die durch Fouriertransformation der einzelnen MR-Signale entstehenden Daten identisch sein. Wegen der Unvollkommenheiten des MR-Systems und wegen der Relaxationsphänomene weichen diese MR-Signale bzw. die daraus erhaltenen Fouriertransformierten voneinander ab. Weil diese Unvollkommenheiten auch noch nach der Erfassung der vier MR-Signale wirksam sind, lassen sich daraus MR-Korrekturdaten ableiten, mit denen die MR-Rohdaten korrigiert werden, die aus den während der Zeitintervalle 45 ... 48 gewonnenen MR-Signalen abgeleitet werden.

Zu diesem Zweck wird gemäß Block 101 von Fig. 4, die einen Teil des Ablaufdiagramms des in der Rekonstruktionseinheit 13 ablaufenden Computerprogramms darstellt, jedes der während der Zeitintervalle 41 ... 44 sowie 45 ... 48 gewonnenen MR-Signale einer eindimensionalen inversen Fouriertransformation unterzogen. Dadurch werden die digitalen, von der Zeit bzw. der Ortsfrequenz $k_x$ in Richtung des Lesegradienten ($k_x$ ist das zeitliche Integral über den Lesegradienten vom Ende des Hochfrequenzimpulses bis zur Erfassung des jeweiligen Abtastwertes in dem MR-Signal) abhängigen komplexen Abtastwerte des MR-Signals umgesetzt in eine Folge von ebenfalls komplexen MR-Daten $S(t,x)$. Dabei bezeichnet der Wert t die zeitliche Lage des MR-Signals innerhalb der Sequenz bzw. die zugehörige Phasenkodierung, und der Wert x eine Position in x-Richtung (x ist die Richtung des Lesegradienten). Die auf diese Weise aus den N während der Zeitabschnitte 45 ... 48 erfaßten MR-Signalen erzeugten MR-Daten sollen im folgenden als MR-Rohdaten bezeichnet werden.

Bei einem idealen MR-System müßten die MR-Daten $S(t_1,x)$ ... $S(t_4,x)$, die aus der Fouriertransformation der vier ersten, während der Zeitabschnitte 41 ... 44 aufgenommenen MR-Signale entstehen, für jeden Zeitpunkt und für jeden Wert x die gleiche Phase haben, doch trifft dies wegen der Unvollkommenheiten des MR-Systems nicht zu. Die Abweichung der jeweiligen Phase von dem Wert Null wird im folgenden als "Pasenfehler" bezeichnet. In den Blöcken 102 und 103 werden daher die Phasenfehler der MR-Rohdaten berechnet. Da die Phasenfehler auch von der Polarität des Lesegradienten abhängen, werden hierfür im folgenden unterschiedliche Symbole gewählt: $\alpha$ für die Phasenfehler bei negativer Polarität und $\beta$ für die Phasenfehler bei positiver Polarität. Die Berechnungen von $\alpha$ und $\beta$ verlaufen ganz analog, weshalb im folgenden nur auf die Berechnung von $\alpha$ näher eingegangen wird.

Der Phasenfehler errechnet sich aus dem Imaginärteil $Im(S(t_i,x))$ und dem Realteil $Re(S(t_i,x))$ des durch die Fouriertransformation erzeugten komplexen Signals $S(t_i,x)$ - $t_i$ kennzeichnet den Zeitpunkt der Erfassung des zugehörigen MR-Signals - nach der Formel

$$\alpha(t_i,x) = \arctan\left[\frac{Im(S(t_i,x))}{Re(S(t_i,x))}\right] \qquad (1)$$

arctan[ ] ist dabei die Umkehrfunktion der Tangensfunktion tan[ ]. Auf diese Weise kann man für jedes der aus den ersten vier MR-Signalen abgeleiteten Signale $S(t_1,x)$ ... $S(t_4,x)$ die Phase als Funktion des Ortes x ableiten. Da der Phasenfehler von x abhängt, wird im folgenden auch der Begriff Phasenfehlerverlauf für $\alpha(t_i,x)$ verwendet.

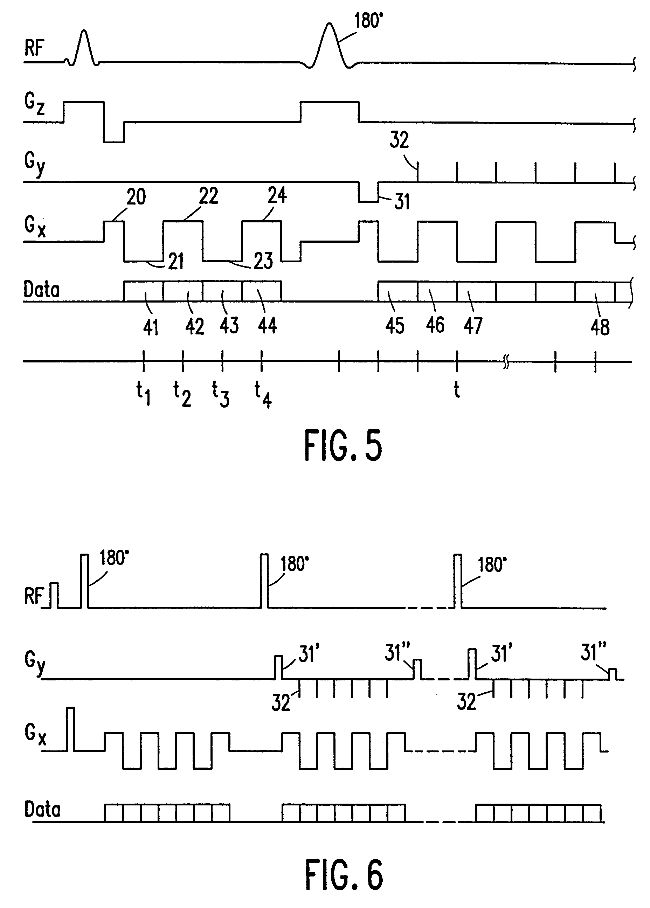

Wie in der EP-OS 490 528, Fig. 6, erläutert, ergibt sich in der Regel eine lineare Abhängigkeit zwischen der Phase $\alpha$ und Ort x. Dementsprechend läßt sich der Phasenfehlerverlauf $\alpha(t_1,x)$ des aus dem ersten MR-Signal durch die Fouriertransformation abgeleiteten Signals $S(t_1,x)$ approximieren durch

$$\alpha(t_1,x) \approx a_{01} + a_{11} \cdot x \qquad (2)$$

Dabei ist $a_{01}$ ein Koeffizient, der die Phase des Signals $S_1(x)$ an der Stelle x=0 (die sog. konstante Phase) angibt und $a_{11}$ ein Koeffizient, der die lineare Änderung der Phase als Funktion von x definiert. Analog dazu ergibt sich für den Phasenverlauf $\alpha(t_3,x)$ des Signals $S(t_3,x)$, das aus dem um den Zeitpunkt $t_3$ auftretenden MR-Signal abgeleitet wird

$$\alpha(t_3,x) \approx a_{03} + a_{13} \cdot x \tag{3}$$

Obwohl die Signale $S(t_1,x)$ und $S(t_3,x)$ von ungeraden Echos herrühren bzw. von MR-Signalen, die jeweils bei derselben (negativen) Polarität des Lesegradienten $G_x$ erfaßt wurden, können insbesondere aufgrund von Inhomogenitäten des vom Hauptfeldmagneten erzeugten stationären Magnetfeldes die Koeffizienten $a_{01}$ und $a_{03}$ einerseits sowie $a_{11}$ und $a_{13}$ andererseits voneinander abweichen.

Die Erfindung basiert auf der Erkenntnis, daß die erwähnten Unvollkommenheiten des Magnetfeldes zu einer im wesentlichen linearen zeitlichen Änderung der Koeffizienten $a_1 \ldots a_{13}$ in den Gleichungen (2) und (3) führen. Demgemäß kann man durch eine lineare Extrapolation den Phasenfehlerverlauf $\alpha(t,x)$ ermitteln, den die Fouriertransformierte eines zu einem späteren Zeitpunkt erfaßten (phasenkodierten) MR-Signals aufgrund der Unvollkommenheiten erfährt. Es gilt

$$a(t,x) = \alpha_{01} + a_{11} \cdot x + (da_0 + da_1 \cdot x) \cdot \frac{t-t_1}{t_3-t_1} \tag{4}$$

mit

$$da_0 = a_{03} - a_{01} \quad \text{und} \quad da_1 = a_{13} - a_{11} \tag{5}$$

Dabei ist t die Mitte des Zeitraums, in dem - ebenfalls bei negativem Lesegradienten - das mit dem Phasenfehlerverlauf $\alpha(t,x)$ behaftete MR-Signal erfaßt wird (vergl. 6. Zeile von Fig. 3).

Die Bestimmung des Phasenfehlers $\alpha(t,x)$ für die MR-Rohdaten, die in Verbindung mit einem negativen Lesegradienten ermittelt wurden, im Block 102 gestaltet sich zusammenfassend also wie folgt:

a) Es werden die Phasenverläufe $\alpha(t_i,x)$ der Fouriertransformierten $S(t_i,x)$ derjenigen von den vier ohne Phasenkodierung aufgenommenen MR-Signale ermittelt, die bei derselben (negativen) Polarität des Lesegradienten erfaßt wurden.

b) Die so ermittelten Phasenverläufe werden durch die linearen Ansätze gemäß den Gleichungen (2) bzw. (3) aproximiert.

c) Aus den sich dabei ergebenden Koeffizienten $a_{01} \ldots a_{13}$ wird gemäß den Gleichungen (4) und (5) der Phasenfehler $\alpha(t,x)$ berechnet, mit dem diejenigen phasenkodierten MR-Signale bzw. deren Fouriertransformierte beaufschlagt sind, die mit der gleichen (negativen) Polarität des Lesegradienten erfaßt wurden.

Im Block 103 wird der Phasenfehlerverlauf $\beta(t,x)$, den diejenigen MR-Signale (bzw. deren Fouriertransformierte $S(t,x)$) aufweisen, die bei positiver Polarität des Lesegradienten $G_x$ entstanden sind, nach analoger Anwendung der Maßnahmen a) bis c) bzw. der Gleichungen (1) bis (5) berechnet entsprechend der Gleichung

$$\beta(t,x) = b_{02} + b_{12} x + (db_0 + db_1 \cdot x) \cdot \frac{t-t_2}{t_4-t_2} \tag{6}$$

Dabei ist $b_{02}$ die Phase des im Zeitintervall 42 (bei positiver Polarität des Lesegradienten) aufgenommenen und einer Fouriertransformation unterzogenen Signals $S(t_2,x)$ für x=0, und $b_{12}$ kennzeichnet die lineare Änderung dieser Phase mit dem Ort x. $t_2$ und $t_4$ stellen die Mitten der Zeiträume 42 und 44 dar, während $db_0$ und $db_1$ angeben, wie sich diese Werte im Zeitintervall zwischen $t_2$ und $t_4$ ändern. Der Wert t stellt in diesem Fall die Mitte eines Zeitraums dar, in dem der Lesegradient positiv ist, z.B. die Mitte eines der Zeiträume 45 oder 47.

Auch wenn die in den MR-Rohdaten enthaltenen Phasenfehler $\alpha(t,x)$ und $\beta(t,x)$ vollständig beseitigt würden, könnten sich immer noch Geisterbilder ergeben, und zwar dann, wenn der Frequenzgang desjenigen Teils des MR-Systems, der die MR-Signale verarbeitet, nicht symmetrisch bezüglich der Mittenfrequenz der MR-Signale verläuft, insbesondere wenn die MR-Empfangsspule nicht exakt auf diese Mittenfrequenz abgestimmt ist. Ein solcher Frequenzgang beeinflußt nämlich die bei positiver Polarität des Lesegradienten akquirierten MR-Rohdaten $S(t,x)$ in anderer Weise als die bei negativer Polarität akquirierten MR-Rohdaten.

Diese Frequenzabhängigkeit läßt sich aber ebenfalls anhand der ohne Phasenkodierung ermittelten MR-Daten $S(t_1,x)$ ... $S(t_4,x)$ beseitigen. Das Spektrum der ohne Phasenkodierungsgradienten akquirierten MR-Signale wird durch den Frequenzgang des MR-Systems beeinflußt. Das gleiche gilt dann für die aus diesen MR-Signalen erzeugten MR-Daten $S(t_1,x)$ ... $S(t_4,x)$, wobei MR-Daten, die bei positiver Polarität des Lesegradienten akquiriert wurden, anders beeinflußt werden als MR-Daten, die bei negativer Polarität des Lesegradienten akquiriert wurden. Infolgedessen kann man aus diesen MR-Daten Korrekturfaktoren A(x) und B(x) ableiten, mit denen der Einfluß der Frequenzabhängigkeit auf die MR-Rohdaten S(t,x) beseitigt werden kann. Für die Berechnung der Korrekturfaktoren A(x) und B(x) sind verschiedene Ansätze möglich:

Bei einem ersten Ansatz werden die Korrekturfaktoren A(x) und B(x) wie folgt bestimmt:

$$A(x) = \frac{|S_b(x)|}{|S_a(x)|} \qquad \text{und } B(x) = 1 \qquad\qquad (7)$$

Dabei ist $|S_a(x)|$ bzw. $|S_b(x)|$ der Betrag von $S_a(x)$ bzw. von $S_b(x)$. $S_a(x)$ stellt die Fouriertransformierte eines der beiden mit negativer Polarität des Lesegradienten aufgenommenen MR-Signale dar (d.h. es entspricht $S(t_1,x)$ oder $S(t_3,x)$. $S_b(x)$ steht für $S(t_2,x)$ bzw. $S(t_4,x)$, die bei positiver Polarität des Lesegradienten ohne Phasenkodierung akquiriert wurde.

Wenn die bei negativer Polarität des Lesegradienten akquirierten MR-Rohdaten S(t,x) mit dem Faktor A(x) und die bei positiver Polarität des Lesegradienten akquirierten MR-Rohdaten mit dem Faktor B(x) entsprechend Gleichung (7) multipliziert werden, dann hat die frequenzabhängige Übertragungsfunktion auf das resultierende Produkt den gleichen Einfluß, so daß zwar die Geisterbilder verschwinden, aber die Frequenzabhängigkeit bleibt.

Günstigere Ergebnisse erhält man mit einem zweiten Ansatz, bei dem A(x) und B(x) wie folgt berechnet werden:

$$A(x) = \frac{1}{2}\cdot\frac{|S_a(x)|+|S_b(x)|}{|S_a(x)| + \delta} \qquad ; \qquad B(x) = \frac{1}{2}\cdot\frac{|S_a(x)|+|S_b(x)|}{|S_b(x)| + \delta} \qquad\qquad (8)$$

Dabei ist $\delta$ ein Regularisierungsparameter, der bei stark mit Rauschen behafteten MR-Daten numerische Diskontinuitäten vermeidet. Durch Multiplikation der MR-Rohdaten mit den Korrekturfaktoren A(x) und B(x) nach Gleichung 8 können nicht nur Geisterbilder vermieden werden, sondern der Einfluß der Frequenzabhängigkeit auf die so korrigierten Rohdaten wird weitgehend eliminiert.

Nachdem auf diese Weise die Korrekturfaktoren A(x) und B(x) in den Blöcken 104 und 105 nach Gleichung (7) oder (8) berechnet worden sind, können aus den MR-Rohdaten, die bei negativer Polarität des Lesegradienten ermittelt worden sind, im Block 106 korrigierte Daten $S_{cor}(t,x)$ berechnet werden nach der Gleichung

$$S_{acor}(t,x) = A(x) \cdot e^{-j\alpha(t,x)} \cdot S_a(x) \qquad\qquad (9)$$

Analog dazu können auch die bei positiver Polarität des Lesegradienten erfaßten MR-Rohdaten im Block 107 korrigiert werden nach der Beziehung

$$S_{bcor}(t,x) = B(x)\cdot e^{-j\beta(t,x)\cdot} S_b(x) \qquad\qquad (10)$$

Nachdem die bei positiver und bei negativer Polarität entstehenden Datensätze $S_{bcor}(t,x)$ und $S_{acor}(t,x)$ zu einem einzigen Datensatz zusammengefügt worden sind, wird aus den Daten, die jeweils dem gleichen Wert x zugeordnet sind, aber einem anderen Zeitpunkt t bzw. einer anderen Phasenkodierung, eine weitere eindimensionale inverse Fouriertransformation durchgeführt (Block 108), woraus sich ein von N/2-Geisterbildern freies Bild der Kernmagnetisierungsverteilung in der durch den schichtselektiven Hochfrequenzimpuls angeregten Schicht ergibt.

Wenn das zeitliche Integral über den Puls 31 des Phasenkodierungsgradienten $G_y$ genau ein ganzzahliges Vielfaches des zeitlichen Integrals über einen blip 32 ist, dann ist für ein dann auftretendes MR-Signal das zeitliche Integral über den Phasenkodierungsgradienten $G_y$ gleich Null (d.h. $k_y = 0$). Das bedeutet, daß dieses MR-Signal frei ist von jeglicher Phasenkodierung. Wenn man dann bei den nächsten drei Polaritätswechseln des Lesegradienten keinen blip schalten würde, könnte man nacheinander vier von jeder Phasenkodierung freie MR-Signale mitten in der Sequenz erfassen und aus ihnen die MR-Korrekturdaten ableiten. Es wäre dann nicht mehr erforderlich, die vier MR-Signale vorab zu erfassen und die Phasenkodierung könnte entsprechend früher einsetzen. Voraussetzung ist allerdings, daß das zeitliche Integral über den Phasenkodiergradienten bis zum Zeitpunkt der Erfassung der für die Bildung der MR-Korrekturdaten herangezogenen MR-Signale gerade Null ist. Ein gewisser Nachteil ist, daß das Signal-Rausch-Verhältnis der nach dem Beginn der Phasenkodierung erhaltenen MR-Signale aufgrund ihres größeren zeitlichen Abstandes vom Hochfrequenz-Anregungsimpuls schlechter ist als das der vor Beginn der Phasenkodierung erhaltenen MR-Signale.

Anstatt die vier zur Bildung der MR-Korrekturdaten herangezogenen MR-Signale entweder vor oder nach Beginn der Phasenkodierung zu erfassen, ist es auch möglich, zwei dieser MR-Signale vor und zwei MR-Signale nach Beginn der Phasenkodierung zu erfassen - und zwar je eines bei positiver und eines bei negativer Polarität des Lesegradienten. Die Phasendifferenzen $da_0$ und $da_1$ (Gleichung 4) bzw. $db_0$ und $db_1$ (Gleichung 6) vergrößern sich dann, was der Genauigkeit bei der Berechnung von $\alpha(t,x)$ und $\beta(t,x)$ zugute kommen kann.

In den meisten Fällen reicht der in den Gleichungen (4) und (6) enthaltene Ansatz, der von einer linearen Zeitabhängigkeit der die Ortsabhängigkeit beschreibenden Koeffizienten $a_{o1}$ ... $a_{13}$ bzw. $b_{02}$ ... usw. ausgeht, aus, um die N/2 Geisterbilder zu kompensieren. Bei größeren Inhomogenitäten des stationären Hauptmagnetfelden können sich zeitlich nichtlineare Änderungen bemerkbar machen, die mit einem quadratischen zeitlichen Ansatz berücksichtigt werden können. Dazu müßten die Phasenfehlerverläufe von (mindestens) drei bei derselben Polarität des Lesegradienten erfaßten MR-Signalen ermittelt werden. Die Koeffizienten des quadratischen zeitlichen Ansatzes werden dann so bestimmt, daß die aus ihnen errechnete zeitliche Abhängigkeit der Phasenverlerverläufe so gut wie möglich mit der bei diesen MR-Signalen gemessenen Zeitabhängigkeit übereinstimmt..

Bei den Gleichungen (2) und (3) ist davon ausgegangen worden, daß der Phasenfehlerverlauf, d.h. die räumliche Abhängigkeit des Phasenfehlers durch einen linearen Ansatz berücksichtigt werden kann, was in der Regel ausreicht. Falls ein solcher linear von x abhängiger Ansatz nicht ausreicht, kann ein Phasenverlauf höherer Ordnung approximiert werden, wobei wiederum davon ausgegangen wird, daß die ermittelten Koeffizienten je für sich linear (oder quadratisch) von der Zeit abhängen.

In Fig. 5 ist eine andere erfindungsgemäß modifizierte EPI-Sequenz dargestellt. Sie unterscheidet sich von der Sequenz nach Fig. 3 dadurch, daß dem schichtselektiven Hochfrequenzimpuls ein schichtselektiver 180°-Hochfrequenzimpuls folgt. Dabei ist es von Vorteil, wenn die vier MR-Signale ohne Phasenkodierung in dem Zeitintervall zwischen den beiden Hochfrequenzimpulsen gewonnen werden und nicht nach dem 180°-Hochfrequenzimpuls. Durch den refokussierenden 180°-Impuls werden sämtliche Phasen - also auch sämtliche Phasenfehler - invertiert. Diese Inversion kann als eine Spiegelung der Zeitachse aufgefaßt werden. Diese somit neue Zeitbasis muß in Gleichung (4) und (6) als eine Verschiebung berücksichtigt werden, um die Phasenfehler der Fouriertransformierten der nachfolgend gemessenen MR-Rohdaten S(t,x) vorherzusagen.

Figur 6 zeigt eine Abwandlung der bekannten GRASE-Sequenz im Sinne der Erfindung. Der zeitliche Verlauf des Schichtselektionsgradienten ist dabei nicht dargestellt. Eine GRASE-Sequenz weist bekanntlich neben einem ersten die Kernmagnetisierung in der anzuregenden Schicht beeinflussenden 90°-Hochfrequenzimpuls eine Reihe von refokussierenden 180°-Hochfrequenzimpulsen auf. Zwischen je zwei 180°-Hochfrequenzimpulsen wird eine - vorzugsweise ungerade Anzahl von MR-Signalen in Verbindung mit einem alternierenden Lesegradienten $G_x$ erfaßt. Zwischen den beiden ersten refokussierenden 180°-Hochfrequenzimpulsen ist keine Phasenkodierung wirksam. Nach dem zweiten und allen weiteren 180°-Hochfrequenzimpulsen wird ein Impuls 31' des Phasenkodierungsgradienten geschaltet, dem synchron mit dem Lesegradienten eine Reihe von blips 32 folgen. Nach den blips und vor dem nächsten 180°-Impuls gibt es einen weiteren Impuls 31", der so bemessen ist, daß das zeitliche Integral über den Phasenkodierungsgradienten zwischen zwei 180°-Impulsen einen konstanten Wert, vorzugsweise den Wert Null,hat. Die Zahl der Polaritätswechsel des Lesegradienten zwischen den beiden ersten Impulsen sollte genauso groß sein wie deren Zahl zwischen allen weiteren Hochfrequenzimpulsen. Von den im ersten Intervall entstehenden, von Phasenkodierung freien MR-Signalen brauchen aber nur vier ausgewertet werden, z.B. die beiden ersten und die beiden letzten MR-Signale. Im vorstehenden wurde beschrieben, wie die zeitabhängigen Phasenfehler für positive und negative Polarität des Lesegradienten korrigiert werden können und wie die Empfänger- und Empfängerspulen-Charakteristik durch einen Amplitudenfaktor korrigiert werden kann. Es ist darüber hinaus aber auch möglich, durch Wirbelströme hervorgerufene Phasenfehler zu korrigierten.

Dazu wird von einer Sequenz ausgegangen, die - beispielsweise wie die in Fig. 6 dargestellte - im Anschluß an einen refokussierenden 180°-Impuls (wenigstens) drei MR-Signale ohne Phasenkodieren umfaßt. Dabei soll die Mitte des zweiten MR-Signals $t_2$ mit dem Zeitpunkt der Refokussierung der Kernmagnetisierung zusammenfallen, d. h. der zeitliche Abstand dieses MR-Signals von dem refokussierenden 180°-Impuls soll so groß sein wie dessen Abstand von dem vorausgehenden 90°-Anregungsimpuls. Weiterhin sei angenommen, daß davor (zur Zeit $t_1$) und danach ein MR-Signal erfaßt worden sein soll, wobei der Lesegradient zur Zeit $t_1$ und $t_3$ die entgegengesetzte Polarität haben möge wie zur Zeit $t_2$. Außerdem soll der zeitliche Abstand zwischen $t_1$ und $t_2$ genau so groß sein wie zwischen $t_2$ und $t_3$.

Dann gilt für die aus diesen drei Signalen durch FourierTransformation abgeleiteten MR-Daten $S(t_1,x)$, $S(t_2, x)$ und $S(t_3,x)$ folgendes hinsichtlich der Phasenfehler: Die Phasenfehler setzen sich zusammen aus einem Anteil $\vartheta$

(x), der durch Magnetfeld-Inhomogenitäten oder Off-Resonanzeffekte bedingt ist, und aus einem Anteil $\varepsilon(x)$, der durch Wirbelstromeffekte hervorgerufen wird. Wegen der Refokussierung zur Zeit $t_2$ haben Magnetfeld-Inhomogenitäten auf den Phasenfehler von $S(t_2,x)$ keinen Einfluß. In den MR-Daten $S(t_1,x)$ und $S(t_3,x)$ hat $\vartheta(x)$ die gleiche Größe aber das entgegengesetzte Vorzeichen, weil der zeitliche Abstand der drei aufeinanderfolgenden MR-Signale gleich ist. Die durch Wirbelströme induzierten Phasenfehler sind ebenfalls in allen MR-Daten $S(t_1,x)$... $S(t_3,x)$ betragsmäßig gleich, jedoch ändern sie ihr Vorzeichen in Abhängigkeit von dem Lesegradienten, der während der Erfassung des zugehörigen MR-Signals wirksam war. Somit lassen sich die resultierenden Phasenfehler für die drei Projektionen wie folgt angeben:

$$\varphi(t_1,x) = -\,\vartheta(x) - \varepsilon(x) \tag{11}$$

$$\varphi(t_2,x) = \qquad + \varepsilon(x) \tag{12}$$

$$\varphi(t_3,x) = +\,\vartheta(x) - \varepsilon(x) \tag{13}$$

Durch geschickte Multipulikation der MR-Daten lassen sich die Therme $\vartheta(x)$ und £(x) isolieren und als Korrektur verwenden. Das Produkt P(x), das sich nach der Formel errechnet:

$$P(x) = S(t_1,x)S^*(t_2,x)S(t_3,x)S^*(t_2,x) \tag{14}$$

(der Therm $S^*(t_2,x)$ steht dabei für den konjugierten komplexen Wert von $S(t_2,x)$) hat eine Phase, die analog zu Gleichung (1) ermittelt werden kann, die dem Vierfachen des Phasenfehlers E(x) entspricht, wobei der so gefundene Wert weitgehend unabhängig von Schaltverzögerungen bei der Erzeugung des Lasegradienten ist. - Der durch die Magnetfeld-Inhomogenitäten verursachte Phasenfehler kann beispielsweise aus dem Produkt $S(t_1,x)$, $S^*(t_3,x)$ ermittelt werden.

## Patentansprüche

**1.** MR-Verfahren mit folgenden Schritten:

a) Anregen der Kernmagnetisierung in einem Untersuchungsbereich, der einem homogenen stationären Magnetfeld ausgesetzt ist, durch eine Sequenz mit wenigstens einem Hochfrequenzimpuls (RF)
b) Danach Erzeugen eines Lesegradienten ($G_x$) mit alternierender Polarität und gleichzeitige Erzeugung eines Phasenkodiergradienten ($G_y$)
c) Erfassen der nach den Polaritätswechseln des Lesegradienten auftretenden MR-Signale zur Gewinnung von MR-Rohdaten (S(t,x))
d) Korrektur der MR-Rohdaten durch MR-Korrekturdaten ($\alpha(t,x)$, $\beta(t,x)$), die aus MR-Signalen abgeleitet werden, die in derselben Sequenz und bei dem gleichen zeitlichen Verlauf des Lesegradienten - aber ohne Phasenkodierung - erfaßt werden
e) Rekonstruktion der Kernmagnetisierungsverteilung aus den korrigierten MR-Rohdaten

**dadurch gekennzeichnet,**
**daß** bei positiver Polarität und bei negativer Polarität des Lesegradienten ($G_x$) insgesamt mindestens drei von dem Phasenkodiergradienten ($G_y$) unbeeinflußte MR-Signale erfaßt werden und daß aus diesen MR-Signalen bzw. den daraus durch eine Fouriertransformation erhaltenen MR-Daten die MR-Korrekturdaten abgeleitet werden.

**2.** MR-Verfahren nach Anspruch 1, **dadurch gekennzeichnet**

- **daß** der Phasenfehlerverlauf (z. B. $\alpha(t_1,x),\alpha(t_3,x)$) dieser MR-Signale bzw der daraus durch eine Fouriertransformation abgeleiteten MR-Daten ($S(t_1,x),S(t_3,x)$) bestimmt wird
- und **daß** aus der zeitlichen Änderung ($da_0,da_1; db_0,db_1$) von der gleichen Polarität des Lesegradienten zugeordneten Phasenfehlerverläufen ($\alpha(t_1,x),\alpha(t_3,x)$) der Phasenfehlerverlauf ($\alpha(t,x)$) von bei dieser Polarität des Lesegradienten in einem anderen Zeitpunkt (t) erfaßten MR-Signalen bzw daraus abgeleiteten MR-Rohdaten (S(t,x)) geschätzt wird und die MR-Rohdaten entsprechend korrigiert werden.

3. MR-Verfahren nach Anspruch 1,
   **dadurch gekennzeichnet,**
   **daß** aus den MR-Daten Korrekturfaktoren abgeleitet werden und daß die bei negativer Polarität des Lesegradienten gewonnenen MR-Rohdaten mit dem einen dieser Korrekturfaktoren (A(x)),und die bei positiver Polarität des Lesegradienten gewonnenen MR-Rohdaten mit dem anderen Korrekturfaktor (B(x))multipliziert werden .

4. MR-Verfahren nach Anspruch 1,
   **dadurch gekennzeichnet,**
   **daß** die Sequenz einen Korrektur-Zeitabschnitt (41...44), in dem die zur Bildung der MR-Korrekturdaten herangezogenen MR-Signale während eines Lesegradienten mit alternierender Polarität ohne Phasenkodierung erfaßt werden, und danach wenigstens einen Meß-Zeitabschnitt (45.....48) aufweist, in dem die zur Bildung der Meßdaten herangezogenen phasenkodierten MR-Signale während eines Lesegradienten mit alternierender Polarität erfaßt werden.

5. MR-Verfahren nach Anspruch 4, **dadurch gekennzeichnet, daß** die Sequenz einen die Kernmagnetisierung anregenden Hochfrequenzimpuls und danach einen die Kernmagnetisierung invertierenden Hochfrequenzimpuls umfaßt, und daß der Korrektur-Zeitabschnitt zwischen den beiden Hochfrequenzimpulsen liegt und der Meß-Zeitabschnitt nach dem invertierenden Hochfrequenzimpuls.

6. MR-Verfahren nach Anspruch 4, **dadurch gekennzeichnet, daß** einem ersten, die Kernmagnetisierung anregenden Hochfrequenzimpuls mehrere Blöcke mit je einem invertierenden Hochfrequenzimpuls und einem Lesegradienten mit jeweils einer bestimmten Anzahl von Polaritätswechseln folgen, und daß der erste Block ohne und die anderen Blöcke mit Einwirkung eines Phasenkodierungsgradienten erfolgen.

7. MR-Gerät zur Durchführung des Verfahrens nach Anspruch 1, mit

   a) einem Hauptfeldmagneten (1) zur Erzeugung eines homogenen stationären Magnetfeldes,
   b) einer Gradienten-Spulenanordnung (3, 5,7) zur Erzeugung eines Lesegradienten ($G_x$) mit alternierender Polarität und zur Erzeugung eines Phasenkodiergradienten ($G_y$),
   c) einer Hochfrequenzspulenanordnung (11) zum Anregen der Kernmagnetisierung in dem Untersuchungsbereich (20) durch eine Sequenz mit wenigstens einen Hochfrequenzimpuls (RF),
   d) einem Empfänger (9) zum Erfassen der während des Lesegradienten erzeugten MR-Signale,
   e) Mitteln (102..104) zur Korrektur der aus den MR-Signalen erzeugten MR-Rohdaten (S(t,x)) durch MR-Korrekturdaten ($\alpha$(t,x);$\beta$(t,x)), die aus MR-daten ohne Phasenkodierung abgeleitet sind,
   f) einer Rekonstruktionseinheit (13,105) zur Rekonstruktion der Kernmagnetisierungsverteilung im Untersuchungsbereich aus den korrigierten MR-Meßdaten
   g) einer Steuereinheit (12) zur Steuerung der Gradientenspulenanordnung (3, 5, 7), der Hochfrequenzspulenanordnung (11) und des Empfängers (9)

   **dadurch gekennzeichnet, daß** die Steuereinheit (12) die Gradientenspulenanordnung und den Empfänger so steuert, daß der Lesegradient und der Phasenkodiergradient während der Sequenz einen solchen zeitlichen Verlauf haben, daß während jeweils zwei oder jeweils drei Zeitabschnitten (41....44) mit sowohl positiver als auch negativer Polarität des Lesegradienten ($G_x$) je ein von dem Phasenkodiergradienten ($G_y$) unbeeinflußtes MR-Signal erfaßt wird, das zur Ableitung der MR-Korrekturdaten herangezogen wird.

## Claims

1. An MR method, comprising the following steps:

   a) excitation of the nuclear magnetization in an examination zone, subject to a uniform, steady magnetic field, by means of a sequence comprising at least one RF pulse (RF),
   b) subsequent generation of a read-out gradient (Gx) of alternating polarity and simultaneous generation of a phase encoding gradient (Gy),
   c) acquisition of the MR signals occurring after the polarity reversal of the read-out gradient in order to acquire MR raw data (S(t,x)),

d) correction of the MR raw data by means of MR correction data (x(t,x), B(t,x)) derived from MR signals acquired in the same sequence and with the same temporal variation of the read-out gradient, however, without phase encoding,

e) reconstruction of the nuclear magnetization distribution from the corrected MR raw data, **characterized in that** with positive polarity and with negative polarity of the read-out gradient ($G_x$) overall at least three MR signals which have not been influenced by the phase encoding gradient (Gy) are acquired, and that the MR correction data is derived from these MR signals or the MR data derived therefrom by Fourier transformation.

2. An MR method as claimed in Claim 1, **characterized in that**

- the phase error variation (for example, $\alpha(t_1,x)$, $\alpha(t_3,x)$) of these MR signals, or of the MR data ($S(t_1,x)$, $S(t_3,x)$) derived therefrom by Fourier transformation, is determined, and that
- from the temporal variation ($da_0$, $da_1$; $db_0$, $db_1$) of the phase error variations ($\alpha(t_1,x)$, $\alpha(t_3,x)$) associated with the same polarity of the read-out gradient there is estimated the phase error variation ($\alpha(t,x)$) of MR signals, acquired with this polarity of the read-out gradient at another instant (t) or of MR raw data ($S(t,x)$) derived therefrom, and the MR raw data is corrected accordingly.

3. An MR method as claimed in Claim 1, **characterized in that** correction factors are derived from the MR data and that the MR raw data acquired with negative polarity of the read-out gradient are multiplied by one of these correction factors (A(x)) while the MR raw data acquired with positive polarity of the read-out gradient are multiplied by the other correction factor (B(x)).

4. An MR method as claimed in Claim 1, **characterized in that** the sequence comprises a correction time interval (41 ... 44) in which the MR signals used to form the MR correction data are acquired during a read-out gradient of alternating polarity without phase encoding, and subsequently at least one measuring time interval (45 ... 48) in which the phase encoded MR signals used to form the measuring data are acquired during a read-out gradient of alternating polarity.

5. An MR method as claimed in Claim 4, **characterized in that** the sequence comprises an RF pulse which excites the nuclear magnetization, succeeded by an RF pulse which inverts the nuclear magnetization, the correction time interval being situated between the two RF pulses whereas the measuring time interval succeeds the inverting RF pulse.

6. An MR method as claimed in Claim 4, **characterized in that** a first RF pulse which excites the nuclear magnetization is succeeded by a plurality of blocks, each of which comprises a respective inverting RF pulse and a read-out gradient with a respective given number of polarity reversals, and that the first block does not involve a phase encoding gradient whereas the other blocks involve a phase encoding gradient.

7. An MR apparatus for carrying out the method claimed in Claim 1, comprising

a) a main field magnet (1) for generating a uniform, steady magnetic field,

b) a gradient coil system (3, 5, 7) for generating a read-out gradient ($G_x$) of alternating polarity and for generating a phase encoding gradient ($G_y$),

c) an RF coil system (11) for exciting the nuclear magnetization in the examination zone (20) by means of a sequence comprising at least one RF pulse (RF),

d) a receiver (9) for receiving the MR signals generated during the read-out gradient,

e) means (102 ... 104) for correcting the MR raw data (S(t,x)), generated from the MR signals, by means of MR correction data ($\alpha(t,x)$; $\beta(t,x)$) derived from MR data without phase encoding,

f) a reconstruction unit (13, 105) for reconstructing the nuclear magnetization distribution in the examination zone from the corrected MR measuring data,

g) a control unit (12) for controlling the gradient coil system (3, 5, 7), the RF coil system (11) and the receiver (9),

**characterized in that** the control unit (12) controls the gradient coil system and the receiver in such a manner that the temporal variation of the read-out gradient and of the phase encoding gradient during the sequence is such that during each time two or three time intervals (41 ... 44) with positive as well as with negative polarity of the read-out gradient ($G_x$) a respective MR signal is acquired which has not been influenced by the phase encoding gradient ($G_y$) and which is used for deriving the MR correction data.

**EP 0 709 690 B1**

**Revendications**

1. Procédé RM comportant les étapes suivantes :

   a) excitation de la magnétisation nucléaire dans une zone d'examen qui est exposée à un champ magnétique stationnaire homogène par une séquence avec au moins une impulsion à haute fréquence (RF),
   b) ensuite, production d'un gradient de lecture ($G_x$) avec une polarité alternée et production simultanée d'un gradient de codage de phase ($G_y$),
   c) saisie des signaux RM produits après les changements de polarité du gradient de lecture pour la production de données brutes RM (S(t,x)),
   d) correction des données brutes RM par des données de correction RM ($\alpha$(t,x), $\beta$ (t,x)) qui sont dérivées des signaux RM qui sont saisis dans la même séquence et avec le même déroulement temporel du gradient de lecture - mais sans codage de phase,
   e) reconstruction de la distribution de la magnétisation nucléaire à partir des données brutes RM corrigées,

   **caractérisé en ce**
   **qu'**en cas de polarité positive et en cas de polarité négative du gradient de lecture ($G_x$), au moins trois des signaux RM non influencés par le gradient de codage de phase (Gy) sont saisis au total et qu'à partir de ces signaux RM ou des données RM obtenues à partir de là par une transformation de Fourier, les données de correction RM sont dérivées.

2. Procédé RM selon la revendication 1, **caractérisé en ce**

   - **que** le tracé des erreurs de phase (p. ex., ($\alpha$($t_1$,x), $\alpha$($t_3$,x)) de ces signaux RM ou des données RM (S($t_1$, x), S($t_3$, x)) dérivées à partir de celles-ci par une transformation de Fourier est déterminé et
   - **qu'**à partir de la variation temporelle (d$a_0$, d$a_1$, d$b_0$, d$b_1$) des tracés d'erreurs de phase ($\alpha$($t_1$,x), $\alpha$($t_3$,x)) affectés à la même polarité du gradient de lecture est estimé le tracé des erreurs de phase ($\alpha$(t,x)) des signaux RM saisis par cette polarité du gradient de lecture à un autre moment (t) ou des données brutes RM (S(t,x)) dérivées de ceux-ci et les données brutes RM sont corrigées en conséquence.

3. Procédé RM selon la revendication 1,
   **caractérisé en ce**
   **que** des facteurs de correction sont dérivés des données RM et que les données brutes RM obtenues en cas de polarité négative du gradient de lecture sont multipliées par l'un de ces facteurs de correction ($A_{(x)}$) et les données brutes RM obtenues en cas de polarité positive du gradient de lecture par l'autre facteur de correction ($B_{(x)}$).

4. Procédé RM selon la revendication 1,
   **caractérisé en ce**
   **que** la séquence d'un segment temporel de correction (41...44) dans lequel les signaux RM utilisés pour la formation des données de correction RM sont saisis pendant un gradient de lecture avec une polarité alternée sans codage de phase et présente ensuite au moins un segment temporel de mesure (45...48) dans lequel les signaux RM à codage de phase utilisés pour la formation des données de mesure sont saisis pendant un gradient de lecture à polarité alternée.

5. Procédé RM selon la revendication 4, **caractérisé en ce**
   **que** la séquence comprend une impulsion à haute fréquence excitant la magnétisation nucléaire et, ensuite, une impulsion à haute fréquence inversant la magnétisation nucléaire et que le segment temporel de correction est situé entre les deux impulsions à haute fréquence et le segment temporel de mesure après l'impulsion inversante à haute fréquence.

6. Procédé RM selon la revendication 4, **caractérisé en ce**
   **qu'**une première impulsion à haute fréquence excitant la magnétisation nucléaire est suivie de plusieurs blocs avec respectivement une impulsion inversante à haute fréquence et un gradient de lecture avec respectivement un nombre déterminé de changements de polarité et que le premier bloc est effectué sans et les autres blocs avec l'action d'un gradient à codage de phase.

7. Appareil RM de mise en oeuvre du procédé selon la revendication 1, avec

a) un aimant de champ principal (1) pour la production d'un champ magnétique stationnaire homogène,

b) un ensemble de bobines à gradient (3,5,7) pour la production d'un gradient de lecture ($G_x$) avec polarité alternée et la production d'un gradient de codage de phase ($G_y$),

c) un ensemble de bobines à haute fréquence (11) pour l'excitation de la magnétisation nucléaire dans la zone d'examen (20) par une séquence avec au moins une impulsion à haute fréquence (RF),

d) un récepteur (9) pour la saisie des signaux RM produits pendant le gradient de lecture;

e) des moyens (102...104) pour la correction des données brutes RM (S(t,x)) produites à partir des signaux RM par des données de correction RM ($\alpha$(t,x), $\beta$ (t,x)) qui sont dérivées des données RM sans codage de phase,

f) une unité de reconstruction (13, 105) pour la reconstruction de la répartition de la magnétisation nucléaire dans la zone d'examen à partir des données de mesure RM corrigées,

g) d'une unité de commande (12) pour la commande de l'ensemble de bobines à gradient (3, 5, 7), de l'ensemble de bobines à haute fréquence (11) et du récepteur (9),

**caractérisé en ce**

**que** l'unité de commande (12) commande l'ensemble de bobines à gradient et le récepteur de telle sorte que le gradient de lecture et le gradient de codage de phase aient pendant la séquence un tracé temporel tel que, pendant respectivement deux ou trois segments temporels (41...44) avec à la fois des polarités positive et négative du gradient de lecture ($G_x$), soit saisi un signal RM non influencé par le gradient à codage de phase ($G_y$) qui est utilisé pour dériver les données de correction RM.

FIG. 1

FIG. 2

FIG. 3

FIG. 4

FIG. 5

FIG. 6

16